# EUROPEAN PATENT APPLICATION

(11) **EP 4 841 896 A1**
(43) Date of publication of application: **18.11.2026**
(21) Application number: 25190322.5
(22) Date of filing: 17.07.2025
(51) Int. Cl.: H03K 17/95, H03K 17/97

(54) **ANTI-INTERFERENCE METHOD FOR HALL SENSOR AND ELECTRONIC DEVICE**

(30) Priority: 13.05.2025 CN 202510611874
(71) Applicant: Li, Wenjie, Guangzhou, Guangdong 510600 (CN)
(72) Inventor: Li, Wenjie, Guangzhou, Guangdong 510600 (CN)
(74) Representative: KIPA AB

(57) **Abstract**

An anti-interference method for hall sensor and an electronic device are disclosed. The method is applied to the electronic device. The electronic device includes a movable switch arranged with a magnet and at least one hall sensor arranged around the movable switch. The anti-interference method for hall sensor includes the following steps: obtaining an application type of the movable switch, and setting an operation range of the hall sensor according to the application type, where the operation range is an electrical signal threshold corresponding to magnetic flux obtained by the hall sensor; obtaining an electrical signal output by the hall sensor based on the magnetic flux between the hall sensor and the magnet during use of the movable switch; and blocking signals output by the hall sensor when the electrical signal output by the hall sensor exceeding the set operation range is determined. The present disclosure solves the problem that the hall sensors in the prior art output incorrect data under magnetic-field interference.

## Description

### FIELD

The present disclosure relates to the technical field of hall sensors, in particular to an anti-interference method for a hall sensor and an electronic device.

### BACKGROUND

Hall sensor is a switch device that operates based on the Hall effect. A main function of the hall sensor is to detect changes in magnetic-field strength, so as to turn on or turn off an electronic device by changing a direction of a current flow. This leads to the sensitivity of the hall sensor to external magnetic-field signal interference. When there is a large amount of external magnetic-field signal interference, the hall sensor is prone to output an incorrect signal due to the external magnetic-field signal interference, and cannot normally control the turn-on and turn-off of the electronic device.

### SUMMARY

In view of the above-mentioned defects of the prior art, the present disclosure provides an anti-interference method for a hall sensor and an electronic device to solve the problem that the hall sensors in the prior art output incorrect data under magnetic-field interference.

The technical solutions of the present disclosure are as follows.

An anti-interference method for hall sensor is disclosed. The anti-interference method for hall sensor is applied to an electronic device, where the electronic device includes a actuatable switch arranged with a magnet and at least one hall sensor arranged around the actuatable switch, and the anti-interference method for hall sensor includes the following steps:
obtaining an application type of the actuatable switch, and setting an operation range of the hall sensor according to the application type, where the operation range is an electrical signal threshold corresponding to magnetic flux obtained by the hall sensor;
obtaining an electrical signal output by the hall sensor based on the magnetic flux between the hall sensor and the magnet during use of the actuatable switch; and,
blocking signals output by the hall sensor when the electrical signal output by the hall sensor exceeding the set operation range is determined.

In some embodiments, the application type of the actuatable switch is a slidable switch, the hall sensor includes a first hall sensor and a second hall sensor respectively arranged at two sides of the magnet, and the step of setting an operation range of the hall sensor according to the application type includes the following steps:
building a first blank coordinate system, where an x-axis of the first blank coordinate system corresponds to a first distance node of the magnet, the first hall sensor, and the second hall sensor, and a y-axis of the first blank coordinate system corresponds to first voltage values output by the first hall sensor and the second hall sensor based on magnetic flux between the first hall sensor and the magnet and magnetic flux between the second hall sensor and the magnet;
obtaining first test voltage values output by the first hall sensor and the second hall sensor based on the magnetic flux between the first hall sensor and the magnet and the magnetic flux between the second hall sensor and the magnet during debugging of the slidable switch; and,
generating a corresponding first voltage operation reference line on the first blank coordinate system based on the first distance node and the first test voltage values, and setting the operation range according to the first voltage operation reference line.

In some embodiments, the step of obtaining an electrical signal output by the hall sensor based on the magnetic flux between the hall sensor and the magnet during use of the actuatable switch includes the following step:
obtaining a first operation voltage value during use of the slidable switch;
where the step of blocking signals output by the hall sensor when the electrical signal output by the hall sensor exceeding the set operation range is determined includes the following step:
   when the first operation voltage value does not fall within the first voltage operation reference line, determining the first operation voltage value exceeds the operation range and blocking the signals output by the hall sensor.

In some embodiments, the application type of the actuatable switch is a rotatable switch, the hall sensor includes a third hall sensor and a fourth hall sensor respectively arranged at two sides of the rotatable switch, and the step of setting an operation range of the hall sensor according to the application type includes the following steps:
building a second blank coordinate system, where an x-axis of the second blank coordinate system corresponds to a rotation angle of the rotatable switch, and a y-axis of the second blank coordinate system corresponds to second voltage values output by the third hall sensor and the fourth hall sensor based on magnetic flux between the third hall sensor and the magnet and magnetic flux between the fourth hall sensor and the magnet;
obtaining second test voltage values output by the third hall sensor and the fourth hall sensor based on the magnetic flux between the third hall sensor and the magnet and the magnetic flux between the fourth hall sensor and the magnet during debugging of the rotatable switch; and,
generating a corresponding second voltage operation reference line on the second blank coordinate system based on the rotation angle of the rotatable switch and the second test voltage values, and setting the operation range according to the second voltage operation reference line.

In some embodiments, the step of obtaining an electrical signal output by the hall sensor based on the magnetic flux between the hall sensor and the magnet during use of the actuatable switch includes the following step:
obtaining a second operation voltage value during use of the rotatable switch;
where the step of blocking signals output by the hall sensor when the electrical signal output by the hall sensor exceeding the set operation range is determined includes the following step:
   when the second operation voltage value does not fall within the second voltage operation reference line, determining the second operation voltage value exceeds the operation range and blocking the signals output by the hall sensor.

In some embodiments, the application type of the actuatable switch is a rotatable ring, the rotatable ring is arranged at a cylinder body and is capable of moving upwards and downwards, the magnet is arranged inside the rotatable ring, the hall sensor includes a fifth hall sensor and a sixth hall sensor respectively arranged at opposite sides of an inner wall of the cylinder body, and the step of setting an operation range of the hall sensor according to the application type includes the following steps:
building a third blank coordinate system, where an x-axis of the third blank coordinate system corresponds to a rotation angle of the rotatable ring, and a y-axis of the third blank coordinate system corresponds to third voltage values output by the fifth hall sensor and the sixth hall sensor based on magnetic flux between the fifth hall sensor and the magnet and magnetic flux between the sixth hall sensor and the magnet;
obtaining third test voltage values output by the fifth hall sensor and the sixth hall sensor based on the magnetic flux between the fifth hall sensor and the magnet and the magnetic flux between the sixth hall sensor and the magnet during debugging of the rotatable ring; and,
generating a corresponding third voltage operation reference line on the third blank coordinate system based on the rotation angle of the rotatable ring and the third test voltage values, and setting the operation range according to the third voltage operation reference line.

In some embodiments, the step of obtaining an electrical signal output by the hall sensor based on the magnetic flux between the hall sensor and the magnet during use of the actuatable switch includes the following step:
obtaining a third operation voltage value during use of the rotatable ring;
where the step of blocking signals output by the hall sensor when the electrical signal output by the hall sensor exceeding the set operation range is determined includes the following step:
   when the third operation voltage value does not fall within the third voltage operation reference line, determining the third operation voltage value exceeds the operation range and blocking the signals output by the hall sensor.

In some embodiments, the application type of the actuatable switch is a rotatable ring, the rotatable ring is arranged at a cylinder body and is capable of moving upwards and downwards, the magnet is arranged inside the rotatable ring, the hall sensor includes a seventh hall sensor and a eighth hall sensor respectively arranged at opposite sides of an inner wall of the cylinder body, the hall sensor further includes a ninth hall sensor arranged below the seventh hall sensor and the eighth hall sensor, and the step of setting an operation range of the hall sensor according to the application type includes the following steps:
building a fourth blank coordinate system, where an x-axis of the fourth blank coordinate system corresponds to a rotation angle of the rotatable ring, and a y-axis of the fourth blank coordinate system corresponds to fourth voltage values output by the seventh hall sensor, the eighth hall sensor, and the ninth hall sensor based on magnetic flux between the seventh hall sensor and the magnet, magnetic flux between the eighth hall sensor and the magnet, and magnetic flux between the ninth hall sensor and the magnet;
obtaining fourth test voltage values output by the seventh hall sensor, the eighth hall sensor, and the ninth hall sensor based on the magnetic flux between the seventh hall sensor and the magnet, the magnetic flux between the eighth hall sensor and the magnet, and the magnetic flux between the ninth hall sensor and the magnet during debugging of the rotatable ring; and,
generating a corresponding fourth voltage operation reference line on the fourth blank coordinate system based on the rotation angle of the rotatable ring and the fourth test voltage values, and setting the operation range according to the fourth voltage operation reference line.

In some embodiments, the step of obtaining an electrical signal output by the hall sensor based on the magnetic flux between the hall sensor and the magnet during use of the actuatable switch includes the following step:
obtaining a fourth operation voltage value during use of the rotatable ring;
where the step of blocking signals output by the hall sensor when the electrical signal output by the hall sensor exceeding the set operation range is determined includes the following step:
   when the fourth operation voltage value does not fall within the fourth voltage operation reference line, determining the fourth operation voltage value exceeds the operation range and blocking the signals output by the hall sensor.

An electronic device is further disclosed, including a processor, a actuatable switch arranged with a magnet, and at least one hall sensor arranged around the actuatable switch, where the processor stores an anti-interference program for the hall sensor, the processor is configured to implement the anti-interference method for hall sensor as described above when executing the anti-interference program for the hall sensor.

In the technical solutions of the present disclosure, the application type of the actuatable switch can be obtained and the operation range of the hall sensor according to the application type can be set. The operation range is the electrical signal threshold corresponding to the magnetic flux obtained by the hall sensor. The electrical signal output by the hall sensor based on the magnetic flux between the hall sensor and the magnet during the use of the actuatable switch is obtained. When it is determined that the electrical signal output by the hall sensor exceeds the set operation range, the output signal of the hall sensor is blocked. In this way, the present disclosure can determine whether the hall sensor is interfered by an external magnetic field by judging a relationship between the voltage value output by the hall sensor and the set operation range during the use of the actuatable switch. When the hall sensor is interfered by the external magnetic field, the output signal of the hall sensor is blocked to avoid outputting an incorrect signal.

### BRIEF DESCRIPTION OF THE DRAWINGS

In order to provide a clearer illustration for the technical solutions in the embodiments of the present disclosure or in the prior art, a brief description is given to the accompanying drawings required for the description of the present embodiments or the prior art. Obviously, the accompanying drawings are only some embodiments of the present disclosure. For those ordinary skilled in the art, other drawings can be obtained based on the accompanying drawings without any creative labor.
FIG. 1 is a flowchart of an anti-interference method for a hall sensor in a first embodiment of the present disclosure.
FIG. 2 is a schematic diagram of an arrangement structure of a first hall sensor, a second hall sensor, and a slidable switch in the present disclosure.
FIG. 3 is a flowchart of an anti-interference method for a hall sensor in a second embodiment in the present disclosure.
FIG. 4 is a two-dimensional quadrant diagram of distance and voltage value of the first hall sensor and the second hall sensor in the present disclosure.
FIG. 5 is a schematic diagram of an arrangement structure of a third hall sensor, a fourth hall sensor, and a rotatable switch in the present disclosure.
FIG. 6 is a flowchart of an anti-interference method for a hall sensor in a third embodiment in the present disclosure.
FIG. 7 is two-dimensional quadrant diagram of angle and voltage value of the third hall sensor and the fourth hall sensor in the present disclosure.
FIG. 8 is a schematic diagram of an arrangement structure of a fifth hall sensor, a sixth hall sensor, and a rotatable ring in the present disclosure.
FIG. 9 is a flowchart of an anti-interference method for a hall sensor in a fourth embodiment in the present disclosure.
FIG. 10 is two-dimensional quadrant diagram of angle and voltage value of the fifth hall sensor and the sixth hall sensor in the present disclosure.
FIG. 11 is a schematic diagram of an arrangement structure of a seventh hall sensor, an eighth hall sensor, a ninth hall sensor, and a rotatable ring in the present disclosure.
FIG. 12 is a flowchart of an anti-interference method for a hall sensor in a fifth embodiment in the present disclosure.
FIG. 13 is two-dimensional quadrant diagram of angle and voltage value of the seventh hall sensor, the eighth hall sensor, and the ninth hall sensor in the present disclosure.

### DETAILED DESCRIPTION OF THE EMBODIMENTS

In order to make the purposes, technical solutions, and effects of the present disclosure clearer and more specific, the present disclosure is further described in detail below with reference to the accompanying drawings and embodiments. It should be understood that the specific embodiments described herein are only used to describe the present disclosure and are not intended to limit the present disclosure.

In the implementation and protection scope of the present disclosure, unless there are special limitations on articles in the text, "a", "an", "said", and "the" may include plural forms. The description related to "first", "second", etc. in the embodiments of the present disclosure are only for descriptive purposes and cannot be understood as indicating or implying their relative importance or implying the number of technical features indicated. Therefore, the features that are limited to "first", "second", etc. can explicitly or implicitly include at least one of these features.

It should be further understood that the terms "include" and "comprise" used in the present disclosure refers to the presence of the described features, integers, steps, operations, elements, and/or components, but does not exclude the presence or addition of one or more other features, integers, steps, operations, elements, components, and/or groups thereof. It should be understood that when one element is "connected" or "coupled" to the other one element, the one element may be directly connected or coupled to the other one element, or there may be an intermediate element present. In addition, the term "connection" or "coupling" used here may include a wireless connection or a wireless coupling. The term "and/or" used here includes all or any one and any combination of one or more associated listed items.

Those skilled in the art can understand that, unless otherwise defined, all terms used here (including technical and scientific terms) have the same meaning as those generally understood by those ordinary skilled in the art to which the present disclosure belongs. It should further be understood that terms such as those defined in general dictionaries should be understood to have the same meaning as those in the context of the prior art, and unless specifically defined as here, the terms will not be interpreted with idealized or overly-formal meanings.

In addition, the technical solutions between various embodiments can be combined with each other, but they must be based on the ability of those ordinary skilled in the art to implement them. When the combination of the technical solutions is contradictory or impossible to implement, it should be considered that the combination of the technical solutions does not exist and is not within the protection scope of the present disclosure.

Hall sensor is a switch device that operates based on the Hall effect. A main function of the hall sensor is to detect changes in magnetic-field strength, so as to turn on or turn off an electronic device by changing a direction of a current flow. This leads to the sensitivity of the hall sensor to external magnetic-field signal interference. When there is a large amount of external magnetic-field signal interference, the hall sensor is prone to output an incorrect signal due to the external magnetic-field signal interference, and cannot normally control the turn-on and turn-off of the electronic device.

To solve the above problem, the present disclosure provides an anti-interference method for a hall sensor. The method is applied to an electronic device. The electronic device includes a actuatable switch arranged with a magnet and at least one hall sensor arranged around the actuatable switch.

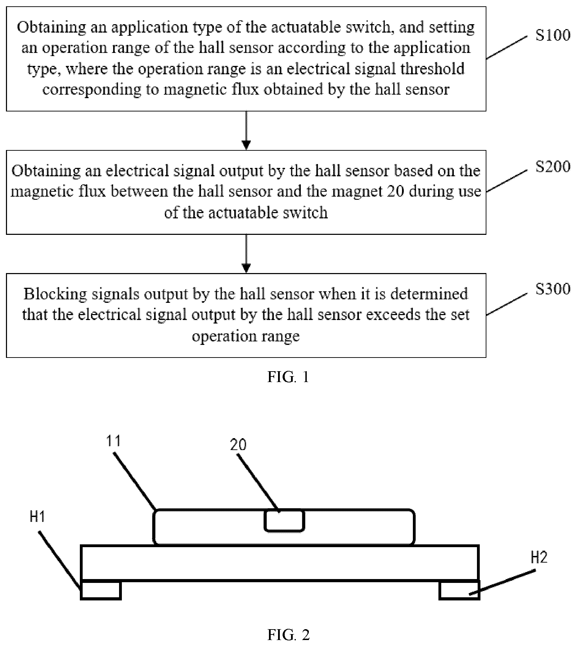

Referring to FIG. 1, in a first embodiment, the anti-interference method for hall sensor includes the following steps:
S100, obtaining an application type of the actuatable switch, and setting an operation range of the hall sensor according to the application type, where the operation range is an electrical signal threshold corresponding to magnetic flux obtained by the hall sensor;
S200, obtaining an electrical signal output by the hall sensor based on the magnetic flux between the hall sensor and the magnet 20 during use of the actuatable switch; and,
S300, blocking signals output by the hall sensor when it is determined that the electrical signal output by the hall sensor exceeds the set operation range.

In the present embodiment, the actuatable switch refers to a switch device having a movable component, and the actuatable switch can be manually operated to change its state (on or off). This type of switch is usually based on a mechanical structure to achieve its functions, relying on the movement, rotation, or pressing of the movable component to control the on and off of a circuit or the operation of other systems. The application type of the actuatable switch represents different types of actuatable switches, such as a slidable switch 11 or a rotatable switch 12. The specific structures of different types of switches are different. Therefore, when the hall sensor detects different actuatable switches, the magnetic flux is different and different electrical signals (such as a voltage signal) are output. A voltage value can be obtained by a subsequent processing device based on converting the voltage signal. In the present embodiment, the operation range of the hall sensor can be set according to the different application types of actuatable switches. It can be understood that the hall sensor is a magnetic sensor based on the Hall effect, used to detect the presence and strength of a magnetic field and output a corresponding electrical signal. Therefore, setting the operation range of the hall sensor can be achieved by obtaining a voltage threshold corresponding to the magnetic flux obtained by the hall sensor. When the electronic device works normally, the actuatable switch is also in use. By obtaining a voltage value obtained by converting the electrical signal output by the hall sensor based on the magnetic flux between the actuatable switch and the magnet 20 during the use of the actuatable switch, and comparing the voltage value with the voltage threshold corresponding to the set operation range, whether the hall sensor is in a normal working condition can be determined. If the voltage value obtained by converting the electrical signal output by the hall sensor during the use of the actuatable switch is the same as the voltage threshold of the set operation range, it is determined that the hall sensor is in the normal working condition and is not interfered by an external magnetic field. If there is a difference between the voltage value obtained by converting the electrical signal output by the hall sensor during the use of the actuatable switch and the voltage threshold of the set operation range, and the difference is small, it is determined that the hall sensor is less interfered by the external magnetic field and the normal working condition is not affected. If there is a difference between the voltage value obtained by converting the electrical signal output by the hall sensor during the use of the actuatable switch and the voltage threshold of the set operation range, and the difference is large, it is determined that the hall sensor is interfered by the external magnetic field; at this time, the output signals of the hall sensor can be blocked to avoid outputting an incorrect signal. A standard of the difference for determining whether the hall sensor is interfered by the external magnetic field can be set according to actual situations and user needs.

In the technical solutions of the present disclosure, the application type of the actuatable switch can be obtained and the operation range of the hall sensor according to the application type can be set. The operation range is the electrical signal threshold corresponding to the magnetic flux obtained by the hall sensor. The electrical signal output by the hall sensor based on the magnetic flux between the hall sensor and the magnet 20 during the use of the actuatable switch is obtained. When it is determined that the electrical signal output by the hall sensor exceeds the set operation range, the output signal of the hall sensor is blocked. In this way, the present disclosure can determine whether the hall sensor is interfered by an external magnetic field by judging a relationship between the voltage value output by the hall sensor and the set operation range during the use of the actuatable switch. When the hall sensor is interfered by the external magnetic field, the output signal of the hall sensor is blocked to avoid outputting an incorrect signal.

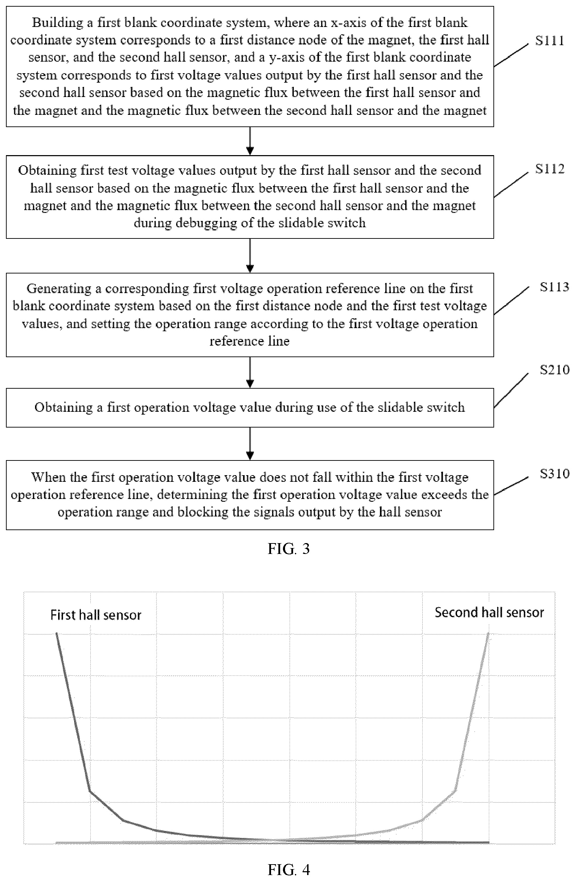

Referring to FIGs. 2 and 3, in a second embodiment, the application type of the actuatable switch is a slidable switch 11, and the hall sensor includes a first hall sensor H1 and a second hall sensor H2 respectively arranged at two sides of the magnet 20. The step of setting an operation range of the hall sensor according to the application type includes the following steps:

S111, building a first blank coordinate system, where an x-axis of the first blank coordinate system corresponds to a first distance node of the magnet 20, the first hall sensor H1, and the second hall sensor H2, and a y-axis of the first blank coordinate system corresponds to first voltage values output by the first hall sensor H1 and the second hall sensor H2 based on the magnetic flux between the first hall sensor H1 and the magnet 20 and the magnetic flux between the second hall sensor H2 and the magnet 20;

S112, obtaining first test voltage values output by the first hall sensor H1 and the second hall sensor H2 based on the magnetic flux between the first hall sensor H1 and the magnet 20 and the magnetic flux between the second hall sensor H2 and the magnet 20 during debugging of the slidable switch 11; and,

S113, generating a corresponding first voltage operation reference line on the first blank coordinate system based on the first distance node and the first test voltage values, and setting the operation range according to the first voltage operation reference line.

In the present embodiment, when the actuatable switch is the slidable switch 11, the first hall sensor H1 and the second hall sensor H2 can be set up and respectively placed at two sides of the magnet 20 for detection, as shown in FIG. 2. Setting the operation range of the hall sensor can be achieved by firstly building the first blank coordinate system, where the x-axis corresponds to the first distance node of the magnet 20, the first hall sensor H1, and the second hall sensor H2, and the y-axis corresponds to the first voltage values output by the first hall sensor H1 and the second hall sensor H2 based on the magnetic flux between the first hall sensor H1 and the magnet 20 and the magnetic flux between the second hall sensor H2 and the magnet 20, secondly controlling the slidable switch 11 to slide to debug the first hall sensor H1 and the second hall sensor H2 and obtaining the first test voltage values output by the first hall sensor H1 and the second hall sensor H2 based on the magnetic flux between the first hall sensor H1 and the magnet 20 and the magnetic flux between the second hall sensor H2 and the magnet 20. In this way, the corresponding first voltage operation reference line can be generated on the first blank coordinate system based on the first distance node and the first test voltage values, and the operation range can be set according to the first voltage operation reference line. In some embodiments, a threshold corresponding to the first voltage values can be set through the first voltage operation reference line, and the threshold may be the same as the first voltage value, or may be increased or decreased according to actual situations and user needs. In the present embodiment, taking the hall sensor operating at 3.5V as an example, the hall sensor actually converts a magnetic flux parameter into the voltage value, and then the voltage value is used for comparison by an external processor. The corresponding experimental data is as follows:

**Table 1**

| First hall sensor | | Second hall sensor | |
|---|---|---|---|
| Distance | Voltage value | Distance | Voltage value |
| 0.01 | 3.39 | 0.15 | 1.766 |
| 0.02 | 2.77 | 0.14 | 1.77 |
| 0.03 | 2.206 | 0.13 | 1.774 |
| 0.04 | 2.007 | 0.12 | 1.779 |
| 0.05 | 1.915 | 0.11 | 1.784 |
| 0.06 | 1.864 | 0.10 | 1.792 |
| 0.07 | 1.833 | 0.09 | 1.801 |
| 0.08 | 1.813 | 0.08 | 1.813 |
| 0.09 | 1.801 | 0.07 | 1.833 |
| 0.10 | 1.792 | 0.06 | 1.864 |
| 0.11 | 1.784 | 0.05 | 1.915 |
| 0.12 | 1.779 | 0.04 | 2.007 |
| 0.13 | 1.774 | 0.03 | 2.206 |
| 0.14 | 1.77 | 0.02 | 2.77 |
| 0.15 | 1.766 | 0.01 | 3.39 |

The unit of Distance is cm, and the unit of Voltage value is v. A corresponding two-dimensional quadrant diagram can be obtained from each electrical signal in Table 1, as shown in FIG. 4.

It should be noted that in the present embodiment, the first hall sensor H1 and the second hall sensor H2 are respectively arranged at two sides of the magnet 20, and the distance between the magnet 20 and the first hall sensor H1 and the distance between the magnet 20 and the second hall sensor H2 are the same. However, in practical applications, the positions of the first hall sensor H1 and the second hall sensor H2 may be changed. For example, if the first hall sensor H1 is arranged at one side and the second hall sensor H2 is arranged below the magnet 20, or if the distance between the magnet 20 and the first hall sensor H1 and the distance between the magnet 20 and the second hall sensor H2 are different, the obtained data and the drawn curve should be inconsistent with those in the present embodiment.

Referring to FIGs. 2 and 3, in the second embodiment, the step of obtaining an electrical signal output by the hall sensor based on the magnetic flux between the hall sensor and the magnet 20 during use of the actuatable switch includes the following step:
S210, obtaining a first operation voltage value during use of the slidable switch 11.

The step of blocking signals output by the hall sensor when it is determined that the electrical signal output by the hall sensor exceeds the set operation range includes the following step:
S310, when the first operation voltage value does not fall within the first voltage operation reference line, determining the first operation voltage value exceeds the operation range and blocking the signals output by the hall sensor.

In the present embodiment, after setting the operation range of the hall sensor, the first operation voltage values output by the first hall sensor H1 and the second hall sensor H2 under normal use of the slidable switch 11 during the operation of the electronic device can be obtained. Then, the first operation voltage value is compared with the voltage threshold corresponding to the operation range of the slidable switch 11. When the first operation voltage value falls within the first voltage operation reference line, it is determined that the first operation voltage value does not exceed the operation range, and the first hall sensor H1 and the second hall sensor H2 work normally. When the first operation voltage value does not fall within the first voltage operation reference line, it is determined that the first operation voltage value exceeds the operation range; at this time, the signals output by the first hall sensor H1 and the second hall sensor H2 are blocked to avoid incorrect signals output by the first hall sensor H1 and the second hall sensor H2. The first operation voltage value not falling within the first voltage operation reference line may be greater or less than the voltage threshold corresponding to the first voltage operation reference line, or the difference between the first operation voltage value and the voltage threshold may be less than a preset value. The preset value can be set according to actual situations and user needs.

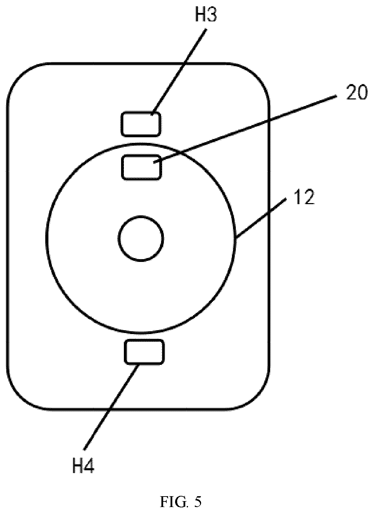

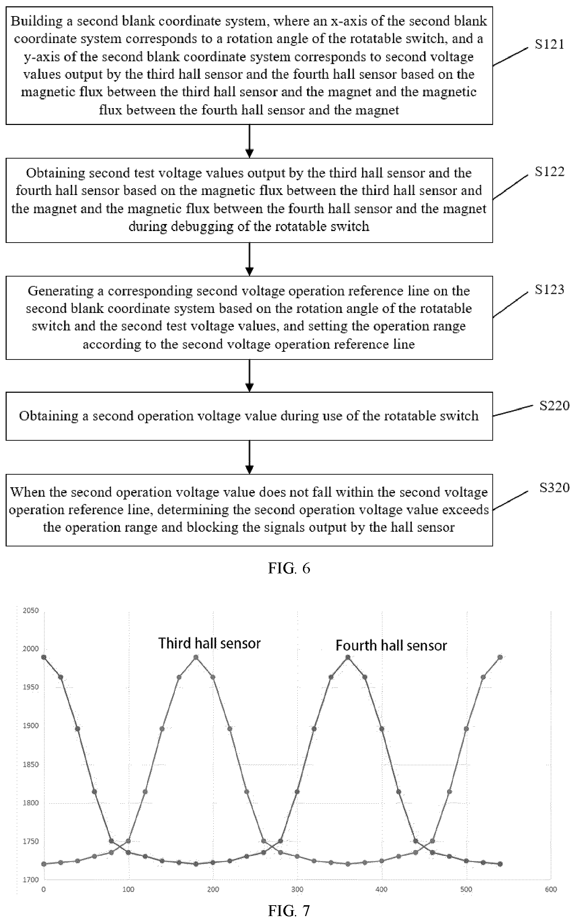

Referring to FIGs. 5 and 6, in a third embodiment, the application type of the actuatable switch is a rotatable switch 12, and the hall sensor includes a third hall sensor H3 and a fourth hall sensor H4 respectively arranged at two sides of the rotatable switch 12. The step of setting an operation range of the hall sensor according to the application type includes the following steps:
S121, building a second blank coordinate system, where an x-axis of the second blank coordinate system corresponds to a rotation angle of the rotatable switch 12, and a y-axis of the second blank coordinate system corresponds to second voltage values output by the third hall sensor H3 and the fourth hall sensor H4 based on the magnetic flux between the third hall sensor H3 and the magnet 20 and the magnetic flux between the fourth hall sensor H4 and the magnet 20;
S122, obtaining second test voltage values output by the third hall sensor H3 and the fourth hall sensor H4 based on the magnetic flux between the third hall sensor H3 and the magnet 20 and the magnetic flux between the fourth hall sensor H4 and the magnet 20 during debugging of the rotatable switch 12; and,
S123, generating a corresponding second voltage operation reference line on the second blank coordinate system based on the rotation angle of the rotatable switch 12 and the second test voltage values, and setting the operation range according to the second voltage operation reference line.

In the present embodiment, when the actuatable switch is the rotatable switch 12, the third hall sensor H3 and the fourth hall sensor H4 can be set up and respectively placed at two sides of the magnet 20 for detection, as shown in FIG. 5. Setting the operation range of the hall sensor can be achieved by firstly building the second blank coordinate system, where the x-axis corresponds to the rotatable angle of the rotatable switch 12, and the y-axis corresponds to the second voltage values output by the third hall sensor H3 and the fourth hall sensor H4 based on the magnetic flux between the third hall sensor H3 and the magnet 20 and the magnetic flux between the fourth hall sensor H4 and the magnet 20, secondly controlling the rotatable switch 12 to rotate to debug the third hall sensor H3 and the fourth hall sensor H4 and obtaining the second test voltage values output by the third hall sensor H3 and the fourth hall sensor H4 based on the magnetic flux between the third hall sensor H3 and the magnet 20 and the magnetic flux between the fourth hall sensor H4 and the magnet 20. In this way, the corresponding second voltage operation reference line can be generated on the second blank coordinate system based on the rotatable angle of the rotatable switch 12 and the second test voltage values, and the operation range can be set according to the second voltage operation reference line. In some embodiments, a threshold corresponding to the second voltage values can be set through the second voltage operation reference line, and the threshold may be the same as the second voltage value, or may be increased or decreased according to actual situations and user needs. In the present embodiment, taking the hall sensor operating at 3.5V as an example, the hall sensor actually converts a magnetic flux parameter into the voltage value, and then the voltage value is used for comparison by an external processor. The corresponding experimental data is as follows:

**Table 2**

| Input voltage value: 3.5V | | | | | | | |
|---|---|---|---|---|---|---|---|
| Angle | 0 | 20 | 40 | 60 | 80 | 100 | 120 |
| Voltage value of the third hall sensor | 1720 | 1722 | 1724 | 1730 | 1735 | 1750 | 1814 |
| Voltage value of the fourth hall sensor | 1989 | 1963 | 1896 | 1814 | 1750 | 1735 | 1730 |

| Angle | 140 | 160 | 180 | 200 | 220 | 240 | 260 |
|---|---|---|---|---|---|---|---|
| Voltage value of the third hall sensor | 1896 | 1963 | 1989 | 1963 | 1896 | 1814 | 1750 |
| Voltage value of the fourth hall sensor | 1724 | 1722 | 1720 | 1722 | 1724 | 1730 | 1735 |

| Angle | 280 | 300 | 320 | 340 | 360 | 380 | 400 |
|---|---|---|---|---|---|---|---|
| Voltage value of the third hall sensor | 1735 | 1730 | 1724 | 1722 | 1720 | 1722 | 1724 |
| Voltage value of the fourth hall sensor | 1750 | 1814 | 1896 | 1963 | 1989 | 1963 | 1896 |

| Angle | 420 | 440 | 460 | 480 | 500 | 520 | 540 |
|---|---|---|---|---|---|---|---|
| Voltage value of the third hall sensor | 1730 | 1735 | 1750 | 1814 | 1896 | 1963 | 1989 |
| Voltage value of the fourth hall sensor | 1814 | 1750 | 1735 | 1730 | 1724 | 1722 | 1720 |

The unit of Voltage value is mv. A corresponding two-dimensional quadrant diagram can be obtained from each electrical signal in Table 2, as shown in FIG. 7.

It should be noted that in the present embodiment, similar to the setting of the slidable switch 11 in the above-mentioned embodiment, it only represents the corresponding curve obtained from the setting positions of the magnet 20, the third hall sensor H3, and the fourth hall sensor H4 in the present embodiment. In other embodiments, the setting positions of the third hall sensor H3 and the fourth hall sensor H4 may be different from those in the present embodiment, and the obtained magnetic flux and the drawn curve should be inconsistent with those in the present embodiment.

Referring to FIGs. 5 and 6, in the third embodiment, the step of obtaining an electrical signal output by the hall sensor based on the magnetic flux between the hall sensor and the magnet 20 during use of the actuatable switch includes the following step:
S220, obtaining a second operation voltage value during use of the rotatable switch 12.

The step of blocking signals output by the hall sensor when it is determined that the electrical signal output by the hall sensor exceeds the set operation range includes the following step:
S320, when the second operation voltage value does not fall within the second voltage operation reference line, determining the second operation voltage value exceeds the operation range and blocking the signals output by the hall sensor.

In the present embodiment, after setting the operation range of the hall sensor, the second operation voltage values output by the third hall sensor H3 and the fourth hall sensor H4 under normal use of the rotatable switch 12 during the operation of the electronic device can be obtained. Then, the second operation voltage value is compared with the voltage threshold corresponding to the operation range of the rotatable switch 12. When the second operation voltage value falls within the second voltage operation reference line, it is determined that the second operation voltage value does not exceed the operation range, and the third hall sensor H3 and the fourth hall sensor H4 work normally. When the second operation voltage value does not fall within the second voltage operation reference line, it is determined that the second operation voltage value exceeds the operation range; at this time, the signals output by the third hall sensor H3 and the fourth hall sensor H4 are blocked to avoid incorrect signal soutput by the third hall sensor H3 and the fourth hall sensor H4. The second operation voltage value not falling within the second voltage operation reference line may be greater or less than the voltage threshold corresponding to the second voltage operation reference line, or the difference between the second operation voltage value and the voltage threshold may be less than a preset value. The preset value can be set according to actual situations and user needs.

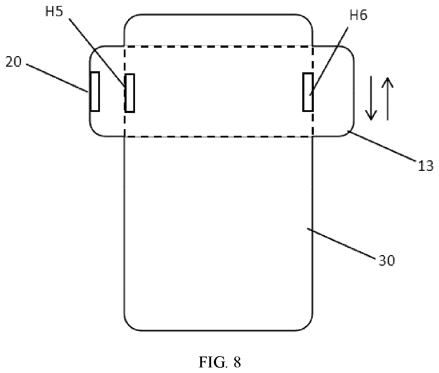

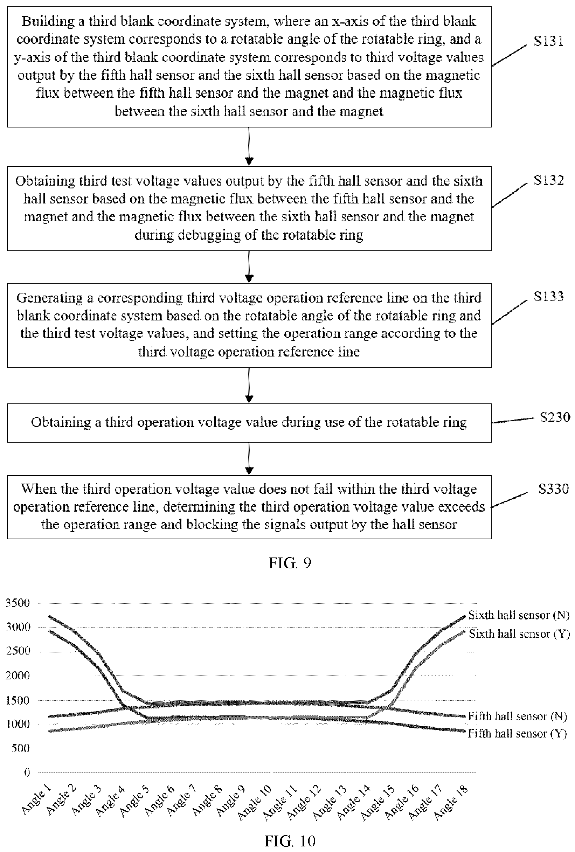

Referring to FIGs. 8 and 9, in a fourth embodiment, the application type of the actuatable switch is a rotatable ring 13. The rotatable ring 13 is arranged at a cylinder body 30 and is capable of moving upwards and downwards. The magnet 20 is arranged inside the rotatable ring 13, and the hall sensor includes a fifth hall sensor H5 and a sixth hall sensor H6 respectively arranged at opposite sides of an inner wall of the cylinder body 30. The step of setting an operation range of the hall sensor according to the application type includes the following steps:
S131, building a third blank coordinate system, where an x-axis of the third blank coordinate system corresponds to a rotatable angle of the rotatable ring 13, and a y-axis of the third blank coordinate system corresponds to third voltage values output by the fifth hall sensor H5 and the sixth hall sensor H6 based on the magnetic flux between the fifth hall sensor H5 and the magnet 20 and the magnetic flux between the sixth hall sensor H6 and the magnet 20;
S132, obtaining third test voltage values output by the fifth hall sensor H5 and the sixth hall sensor H6 based on the magnetic flux between the fifth hall sensor H5 and the magnet 20 and the magnetic flux between the sixth hall sensor H6 and the magnet 20 during debugging of the rotatable ring 13; and,
S133, generating a corresponding third voltage operation reference line on the third blank coordinate system based on the rotatable angle of the rotatable ring 13 and the third test voltage values, and setting the operation range according to the third voltage operation reference line.

In the present embodiment, when the actuatable switch is the rotatable ring 13, the fifth hall sensor H5 and the sixth hall sensor H6 can be set up and respectively placed at opposite sides of the inner wall of the cylinder body 30 for detection, as shown in FIG. 8. Setting the operation range of the hall sensor can be achieved by firstly building the third blank coordinate system, where the x-axis corresponds to the rotatable angle of the rotatable ring 13, and the y-axis corresponds to the third voltage values output by the fifth hall sensor H5 and the sixth hall sensor H6 based on the magnetic flux between the fifth hall sensor H5 and the magnet 20 and the magnetic flux between the sixth hall sensor H6 and the magnet 20, secondly controlling the rotatable ring 13 to rotate to debug the fifth hall sensor H5 and the xixth hall sensor H6 and obtaining the third test voltage values output by the fifth hall sensor H5 and the sixth hall sensor H6 based on the magnetic flux between the fifth hall sensor H5 and the magnet 20 and the magnetic flux between the sixth hall sensor H6 and the magnet 20. In this way, the corresponding third voltage operation reference line can be generated on the third blank coordinate system based on the rotatable angle of the rotatable ring 13 and the third test voltage values, and the operation range can be set according to the third voltage operation reference line. In some embodiments, a threshold corresponding to the third voltage values can be set through the third voltage operation reference line, and the threshold may be the same as the third voltage value, or may be increased or decreased according to actual situations and user needs. In the present embodiment, taking the hall sensor operating at 3.5V as an example, the hall sensor actually converts a magnetic flux parameter into the voltage value, and then the voltage value is used for comparison by an external processor. The corresponding experimental data is as follows:

**Table 3**

| | Angle 1 | Angle 2 | Angle 3 | Angle 4 | Angle 5 | Angle 6 |
|---|---|---|---|---|---|---|
| Voltage value of the fifth hall sensor (N) | 3213 | 2914 | 2451 | 1687 | 1423 | 1440 |
| Voltage value of the sixth hall sensor (N) | 1150 | 1193 | 1240 | 1313 | 1350 | 1380 |
| Voltage value of the fifth hall sensor (Y) | 2913 | 2614 | 2151 | 1387 | 1123 | 1140 |
| Voltage value of the sixth hall sensor (Y) | 850 | 893 | 940 | 1013 | 1050 | 1080 |

| | Angle 7 | Angle 8 | Angle 9 | Angle 10 | Angle 11 | Angle 12 |
|---|---|---|---|---|---|---|
| Voltage value of the fifth hall sensor (N) | 1439 | 1445 | 1432 | 1423 | 1414 | 1404 |
| Voltage value of the sixth hall sensor (N) | 1404 | 1414 | 1423 | 1432 | 1445 | 1439 |
| Voltage value of the fifth hall sensor (Y) | 1139 | 1145 | 1132 | 1123 | 1114 | 1104 |
| Voltage value of the sixth hall sensor (Y) | 1104 | 1114 | 1123 | 1132 | 1145 | 1139 |

| | Angle 13 | Angle 14 | Angle 15 | Angle 16 | Angle 17 | Angle 18 |
|---|---|---|---|---|---|---|
| Voltage value of the fifth hall sensor (N) | 1380 | 1350 | 1313 | 1240 | 1193 | 1150 |
| Voltage value of the sixth hall sensor (N) | 1440 | 1423 | 1687 | 2451 | 2914 | 3213 |
| Voltage value of the fifth hall sensor (Y) | 1080 | 1050 | 1013 | 940 | 893 | 850 |
| Voltage value of the sixth hall sensor (Y) | 1140 | 1123 | 1387 | 2151 | 2614 | 2913 |

The unit of Voltage value is mv. The angles corresponding to Angles 1 to 18 may refer to the angles in the above-mentioned embodiment. A corresponding two-dimensional quadrant diagram can be obtained from each electrical signal in Table 3, as shown in FIG. 10.

It should be noted that in the present embodiment, when debugging the rotation of the rotatable ring 13 which does not move downwards (marked as N) and the rotation of the rotatable ring 13 which moves downwards (marked as Y), four reference curves are generated in the third blank coordinate system for the fifth hall sensor H5 and the sixth hall sensor H6. The reference curve is a reference range. The up and down movement of the rotatable ring can be used to convert device functions. For example, when the rotatable ring is in the N state, the rotatable ring is used to perform data adjustment of function A, and when the rotatable ring is in the Y state, the rotatable ring is used to perform data adjustment of function B.

Referring to FIGs. 8 and 9, in the fourth embodiment, the step of obtaining an electrical signal output by the hall sensor based on the magnetic flux between the hall sensor and the magnet 20 during use of the actuatable switch includes the following step:
S230, obtaining a third operation voltage value during use of the rotatable ring 13.

The step of blocking signals output by the hall sensor when it is determined that the electrical signal output by the hall sensor exceeds the set operation range includes the following step:

S330, when the third operation voltage value does not fall within the third voltage operation reference line, determining the third operation voltage value exceeds the operation range and blocking the signals output by the hall sensor.

In the present embodiment, after setting the operation range of the hall sensor, the third operation voltage values output by the fifth hall sensor H5 and the sixth hall sensor H6 under normal use of the rotatable ring 13 during the operation of the electronic device can be obtained. Then, the third operation voltage value is compared with the voltage threshold corresponding to the operation range of the rotatable ring 13. When the third operation voltage value falls within the third voltage operation reference line, it is determined that the third operation voltage value does not exceed the operation range, and the fifth hall sensor H5 and the sixth hall sensor H6 work normally. When the third operation voltage value does not fall within the third voltage operation reference line, it is determined that the third operation voltage value exceeds the operation range; at this time, the signals output by the fifth hall sensor H5 and the sixth hall sensor H6 are blocked to avoid incorrect signals output by the fifth hall sensor H5 and the sixth hall sensor H6. The third operation voltage value not falling within the third voltage operation reference line may be greater or less than the voltage threshold corresponding to the third voltage operation reference line, or the difference between the third operation voltage value and the voltage threshold may be less than a preset value. The preset value can be set according to actual situations and user needs.

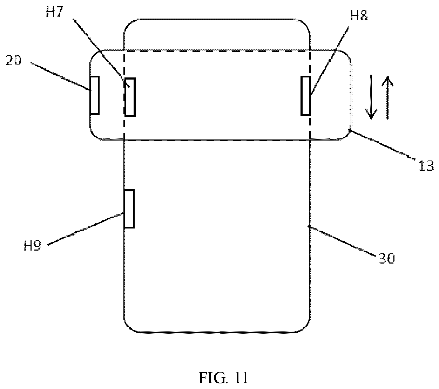

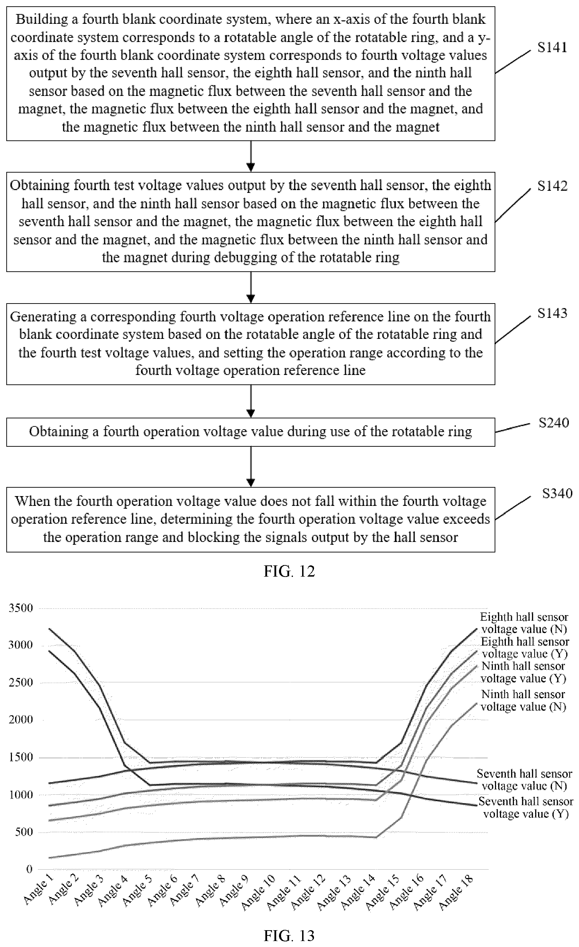

Furthermore, referring to FIGs. 11 and 12, in a fifth embodiment, the application type of the actuatable switch is a rotatable ring 13. The rotatable ring 13 is arranged at a cylinder body 30 and is capable of moving upwards and downwards. The magnet 20 is arranged inside the rotatable ring 13. The hall sensor includes a seventh hall sensor H7 and a eighth hall sensor H8 respectively arranged at opposite sides of an inner wall of the cylinder body 30, and the hall sensor further includes a ninth hall sensor H9 arranged below the seventh hall sensor H7 and the eighth hall sensor H8. The step of setting an operation range of the hall sensor according to the application type includes the following steps:
S141, building a fourth blank coordinate system, where an x-axis of the fourth blank coordinate system corresponds to a rotatable angle of the rotatable ring 13, and a y-axis of the fourth blank coordinate system corresponds to fourth voltage values output by the seventh hall sensor H7, the eighth hall sensor H8, and the ninth hall sensor H9 based on the magnetic flux between the seventh hall sensor H7 and the magnet 20, the magnetic flux between the eighth hall sensor H8 and the magnet 20, and the magnetic flux between the ninth hall sensor H9 and the magnet 20;
S142, obtaining fourth test voltage values output by the seventh hall sensor H7, the eighth hall sensor H8, and the ninth hall sensor H9 based on the magnetic flux between the seventh hall sensor H7 and the magnet 20, the magnetic flux between the eighth hall sensor H8 and the magnet 20, and the magnetic flux between the ninth hall sensor H9 and the magnet 20 during debugging of the rotatable ring 13; and,
S143, generating a corresponding fourth voltage operation reference line on the fourth blank coordinate system based on the rotatable angle of the rotatable ring 13 and the fourth test voltage values, and setting the operation range according to the fourth voltage operation reference line.

In the present embodiment, the type of the actuatable switch is still the rotatable ring 13. Based on the above-mentioned embodiment, one hall sensor is added to make the test more accurate, and a specific structure can refer to FIG. 11. A specific principle of setting the operation range of the hall sensor can refer to the description of the rotatable ring 13 in the above-mentioned embodiment, and is not repeated here. The experimental data when setting the seventh hall sensor H7, the eighth hall sensor H8, and the ninth hall sensor H9 is as follows:

**Table 4**

| | Angle 1 | Angle 2 | Angle 3 | Angle 4 | Angle 5 | Angle 6 |
|---|---|---|---|---|---|---|
| Voltage value of the seventh hall sensor (N) | 3213 | 2914 | 2451 | 1687 | 1423 | 1440 |
| Voltage value of the eighth hall sensor (N) | 1150 | 1193 | 1240 | 1313 | 1350 | 1380 |
| Voltage value of the ninth hall sensor (N) | 150 | 193 | 240 | 313 | 350 | 380 |
| Voltage value of the seventh hall sensor (Y) | 2913 | 2614 | 2151 | 1387 | 1123 | 1140 |
| Voltage value of the eighth hall sensor (Y) | 850 | 893 | 940 | 1013 | 1050 | 1080 |
| Voltage value of the ninth hall sensor (Y) | 650 | 693 | 740 | 813 | 850 | 880 |

| | Angle 7 | Angle 8 | Angle 9 | Angle 10 | Angle 11 | Angle 12 |
|---|---|---|---|---|---|---|
| Voltage value of the seventh hall sensor (N) | 1439 | 1445 | 1432 | 1423 | 1414 | 1404 |
| Voltage value of the eighth hall sensor (N) | 1404 | 1414 | 1423 | 1432 | 1445 | 1439 |
| Voltage value of the ninth hall sensor (N) | 404 | 414 | 423 | 432 | 445 | 439 |
| Voltage value of the seventh hall sensor (Y) | 1139 | 1145 | 1132 | 1123 | 1114 | 1104 |
| Voltage value of the eighth hall sensor (Y) | 1104 | 1114 | 1123 | 1132 | 1145 | 1139 |
| Voltage value of the ninth hall sensor (Y) | 904 | 914 | 923 | 932 | 945 | 939 |

| | Angle 13 | Angle 14 | Angle 15 | Angle 16 | Angle 17 | Angle 18 |
|---|---|---|---|---|---|---|
| Voltage value of the seventh hall sensor (N) | 1380 | 1350 | 1313 | 1240 | 1193 | 1150 |
| Voltage value of the eighth hall sensor (N) | 1440 | 1423 | 1687 | 2451 | 2914 | 3213 |
| Voltage value of the ninth hall sensor (N) | 440 | 423 | 687 | 1451 | 1914 | 2213 |
| Voltage value of the seventh hall sensor (Y) | 1080 | 1050 | 1013 | 940 | 893 | 850 |
| Voltage value of the eighth hall sensor (Y) | 1140 | 1123 | 1387 | 2151 | 2614 | 2913 |
| Voltage value of the ninth hall sensor (Y) | 940 | 923 | 1187 | 1951 | 2414 | 2713 |

The unit of Voltage value is mv. The angles corresponding to Angles 1 to 18 may refer to the angles in the above-mentioned embodiment. A corresponding two-dimensional quadrant diagram can be obtained from each electrical signal in Table 3, as shown in FIG. 13.

It should be noted that in the present embodiment, when debugging the rotation of the rotatable ring 13 which does not move downwards (marked as N) and the rotation of the rotatable ring 13 which moves downwards (marked as Y), six reference curves are generated in the fourth blank coordinate system for the seventh hall sensor H7, the eighth hall sensor H8, and the ninth hall sensor H9. The reference curve is a reference range.

Referring to FIGs. 11 and 12, in the fifth embodiment, the step of obtaining an electrical signal output by the hall sensor based on the magnetic flux between the hall sensor and the magnet 20 during use of the actuatable switch includes the following step:
S240, obtaining a fourth operation voltage value during use of the rotatable ring 13.

The step of blocking signals output by the hall sensor when it is determined that the electrical signal output by the hall sensor exceeds the set operation range includes the following step:
S340, when the fourth operation voltage value does not fall within the fourth voltage operation reference line, determining the fourth operation voltage value exceeds the operation range and blocking the signals output by the hall sensor.

In the present embodiment, the specific working principle and the determining principle can refer to the description of the rotatable ring 13 in the above-mentioned embodiment, and are not repeated here.

The present disclosure further provides an electronic device.

In one embodiment, the electronic device includes a processor, a actuatable switch arranged with a magnet 20, and at least one hall sensor arranged around the actuatable switch. The processor stores an anti-interference program for the hall sensor. The processor is configured to implement the anti-interference method for the hall sensor as described above when executing the anti-interference program for the hall sensor. In the present embodiment, the processor may be a Digital Signal Processor (DSP), a Programmable Logic Device (PLD), a Field Programmable Gate Array (FPGA), a microprocessor, an MCU microcontroller, or other electronic components. The specific settings and working principles of the actuatable switch and the hall sensor arranged with the magnet 20 can refer to the above embodiments. The electronic device may be a flashlight, a headlight, etc.

It should be understood that the applications of the present disclosure are not limited to the above embodiments. For those skilled in the art, improvements or transformations can be made based on the above description, and all these improvements and transformations should fall within the protection scope of the claims attached to the present disclosure.

## Claims

1. An anti-interference method for hall sensor, applied to an electronic device, wherein the electronic device comprises a actuatable switch arranged with a magnet and at least one hall sensor arranged around the actuatable switch, and the anti-interference method for hall sensor comprises the following steps:
obtaining an application type of the actuatable switch, and setting an operation range of the hall sensor according to the application type, wherein the operation range is an electrical signal threshold corresponding to magnetic flux obtained by the hall sensor;
obtaining an electrical signal output by the hall sensor based on the magnetic flux between the hall sensor and the magnet during use of the actuatable switch; and,
blocking signals output by the hall sensor when the electrical signal output by the hall sensor exceeding the set operation range is determined.

2. The anti-interference method for hall sensor according to claim 1, wherein the application type of the actuatable switch is a slidable switch, the hall sensor comprises a first hall sensor and a second hall sensor respectively arranged at two sides of the magnet, and the step of setting an operation range of the hall sensor according to the application type comprises the following steps:
building a first blank coordinate system, wherein an x-axis of the first blank coordinate system corresponds to a first distance node of the magnet, the first hall sensor, and the second hall sensor, and a y-axis of the first blank coordinate system corresponds to first voltage values output by the first hall sensor and the second hall sensor based on magnetic flux between the first hall sensor and the magnet and magnetic flux between the second hall sensor and the magnet;
obtaining first test voltage values output by the first hall sensor and the second hall sensor based on the magnetic flux between the first hall sensor and the magnet and the magnetic flux between the second hall sensor and the magnet during debugging of the slidable switch; and,
generating a corresponding first voltage operation reference line on the first blank coordinate system based on the first distance node and the first test voltage values, and setting the operation range according to the first voltage operation reference line.

3. The anti-interference method for hall sensor according to claim 2, wherein the step of obtaining an electrical signal output by the hall sensor based on the magnetic flux between the hall sensor and the magnet during use of the actuatable switch comprises the following step:
obtaining a first operation voltage value during use of the slidable switch;
wherein the step of blocking signals output by the hall sensor when the electrical signal output by the hall sensor exceeding the set operation range is determined comprises the following step:
when the first operation voltage value does not fall within the first voltage operation reference line, determining the first operation voltage value exceeds the operation range and blocking the signals output by the hall sensor.

4. The anti-interference method for hall sensor according to claim 1, wherein the application type of the actuatable switch is a rotatable switch, the hall sensor comprises a third hall sensor and a fourth hall sensor respectively arranged at two sides of the rotatable switch, and the step of setting an operation range of the hall sensor according to the application type comprises the following steps:
building a second blank coordinate system, wherein an x-axis of the second blank coordinate system corresponds to a rotation angle of the rotatable switch, and a y-axis of the second blank coordinate system corresponds to second voltage values output by the third hall sensor and the fourth hall sensor based on magnetic flux between the third hall sensor and the magnet and magnetic flux between the fourth hall sensor and the magnet;
obtaining second test voltage values output by the third hall sensor and the fourth hall sensor based on the magnetic flux between the third hall sensor and the magnet and the magnetic flux between the fourth hall sensor and the magnet during debugging of the rotatable switch; and,
generating a corresponding second voltage operation reference line on the second blank coordinate system based on the rotation angle of the rotatable switch and the second test voltage values, and setting the operation range according to the second voltage operation reference line.

5. The anti-interference method for hall sensor according to claim 4, wherein the step of obtaining an electrical signal output by the hall sensor based on the magnetic flux between the hall sensor and the magnet during use of the actuatable switch comprises the following step:
obtaining a second operation voltage value during use of the rotatable switch;
wherein the step of blocking signals output by the hall sensor when the electrical signal output by the hall sensor exceeding the set operation range is determined comprises the following step:
when the second operation voltage value does not fall within the second voltage operation reference line, determining the second operation voltage value exceeds the operation range and blocking the signals output by the hall sensor.

6. The anti-interference method for hall sensor according to claim 1, wherein the application type of the actuatable switch is a rotatable ring, the rotatable ring is arranged at a cylinder body and is configured to move upwards and downwards, the magnet is arranged inside the rotatable ring, the hall sensor comprises a fifth hall sensor and a sixth hall sensor respectively arranged at opposite sides of an inner wall of the cylinder body, and the step of setting an operation range of the hall sensor according to the application type comprises the following steps:
building a third blank coordinate system, wherein an x-axis of the third blank coordinate system corresponds to a rotation angle of the rotatable ring, and a y-axis of the third blank coordinate system corresponds to third voltage values output by the fifth hall sensor and the sixth hall sensor based on magnetic flux between the fifth hall sensor and the magnet and magnetic flux between the sixth hall sensor and the magnet;
obtaining third test voltage values output by the fifth hall sensor and the sixth hall sensor based on the magnetic flux between the fifth hall sensor and the magnet and the magnetic flux between the sixth hall sensor and the magnet during debugging of the rotatable ring; and,
generating a corresponding third voltage operation reference line on the third blank coordinate system based on the rotation angle of the rotatable ring and the third test voltage values, and setting the operation range according to the third voltage operation reference line.

7. The anti-interference method for hall sensor according to claim 6, wherein the step of obtaining an electrical signal output by the hall sensor based on the magnetic flux between the hall sensor and the magnet during use of the actuatable switch comprises the following step:
obtaining a third operation voltage value during use of the rotatable ring;
wherein the step of blocking signals output by the hall sensor when the electrical signal output by the hall sensor exceeding the set operation range is determined comprises the following step:
when the third operation voltage value does not fall within the third voltage operation reference line, determining the third operation voltage value exceeds the operation range and blocking the signals output by the hall sensor.

8. The anti-interference method for hall sensor according to claim 1, wherein the application type of the actuatable switch is a rotatable ring, the rotatable ring is arranged at a cylinder body and is configured to move upwards and downwards, the magnet is arranged inside the rotatable ring, the hall sensor comprises a seventh hall sensor and a eighth hall sensor respectively arranged at opposite sides of an inner wall of the cylinder body, the hall sensor further comprises a ninth hall sensor arranged below the seventh hall sensor and the eighth hall sensor, and the step of setting an operation range of the hall sensor according to the application type comprises the following steps:
building a fourth blank coordinate system, wherein an x-axis of the fourth blank coordinate system corresponds to a rotation angle of the rotatable ring, and a y-axis of the fourth blank coordinate system corresponds to fourth voltage values output by the seventh hall sensor, the eighth hall sensor, and the ninth hall sensor based on magnetic flux between the seventh hall sensor and the magnet, magnetic flux between the eighth hall sensor and the magnet, and magnetic flux between the ninth hall sensor and the magnet;
obtaining fourth test voltage values output by the seventh hall sensor, the eighth hall sensor, and the ninth hall sensor based on the magnetic flux between the seventh hall sensor and the magnet, the magnetic flux between the eighth hall sensor and the magnet, and the magnetic flux between the ninth hall sensor and the magnet during debugging of the rotatable ring; and,
generating a corresponding fourth voltage operation reference line on the fourth blank coordinate system based on the rotation angle of the rotatable ring and the fourth test voltage values, and setting the operation range according to the fourth voltage operation reference line.

9. The anti-interference method for hall sensor according to claim 8, wherein the step of obtaining an electrical signal output by the hall sensor based on the magnetic flux between the hall sensor and the magnet during use of the actuatable switch comprises the following step:
obtaining a fourth operation voltage value during use of the rotatable ring;
wherein the step of blocking signals output by the hall sensor when the electrical signal output by the hall sensor exceeding the set operation range is determined comprises the following step:
when the fourth operation voltage value does not fall within the fourth voltage operation reference line, determining the fourth operation voltage value exceeds the operation range and blocking the signals output by the hall sensor.

10. An electronic device , comprising a processor, a actuatable switch arranged with a magnet, and at least one hall sensor arranged around the actuatable switch, wherein the processor stores an anti-interference program for the hall sensor, the processor is configured to implement the anti-interference method for hall sensor according to any one of claim 1 to 9 when executing the anti-interference program for the hall sensor.

## Amended claims

### Amended claims in accordance with Rule 137(2) EPC.

1. An anti-interference method for hall sensor, applied to an electronic device, wherein the electronic device comprises an actuatable switch (13) arranged with a magnet (20) and hall sensors (H7, H8) arranged around the actuatable switch (13),
wherein the application type of the actuatable switch is a rotatable ring (13), the rotatable ring is arranged at a cylinder body (30) and is configured to move upwards and downwards, the magnet (20) is arranged inside the rotatable ring (13), the hall sensors comprise a seventh hall sensor (H7) and an eighth hall sensor (H8) respectively arranged at opposite sides of an inner wall of the cylinder body (30),
the anti-interference method for hall sensors comprises the following steps:
obtaining an application type of the actuatable switch (13), and setting an operation range of the hall sensors (H7, H8) according to the application type, wherein the operation range is an electrical signal threshold corresponding to magnetic flux obtained by the hall sensors;
obtaining an electrical signal output by the hall sensors (H7, H8) based on the magnetic flux between the hall sensors and the magnet (20) during use of the actuatable switch; and,
blocking signals output by the hall sensors (H7, H8) when the electrical signal output by the hall sensor exceeding the set operation range is determined;
**characterized in that** the hall sensors further comprise a ninth hall sensor (H9) arranged below the seventh hall sensor (H7) and the eighth hall sensor (H8), and **in that** the step of setting an operation range of the hall sensors according to the application type comprises the following steps:
building a fourth blank coordinate system, wherein an x-axis of the fourth blank coordinate system corresponds to a rotation angle of the rotatable ring (13), and a y-axis of the fourth blank coordinate system corresponds to fourth voltage values output by the seventh hall sensor (H7), the eighth hall sensor (H8), and the ninth hall sensor (H9) based on magnetic flux between the seventh hall sensor (H7) and the magnet (20), magnetic flux between the eighth hall sensor (H8) and the magnet (20), and magnetic flux between the ninth hall sensor (H9) and the magnet (20);
obtaining fourth test voltage values output by the seventh hall sensor (H7), the eighth hall sensor (H8), and the ninth hall sensor (H9) based on the magnetic flux between the seventh hall sensor (H7) and the magnet (20), the magnetic flux between the eighth hall sensor (H8) and the magnet (20), and the magnetic flux between the ninth hall sensor (H9) and the magnet (20) during debugging of the rotatable ring (13); and,
generating a corresponding fourth voltage operation reference line on the fourth blank coordinate system based on the rotation angle of the rotatable ring (13) and the fourth test voltage values, and setting the operation range according to the fourth voltage operation reference line.

2. The anti-interference method for hall sensor according to claim 1, wherein the step of obtaining an electrical signal output by the hall sensors (H7, H8, H9) based on the magnetic flux between the hall sensors (H7, H8, H9) and the magnet (20) during use of the actuatable switch comprises the following step:
obtaining a fourth operation voltage value during use of the rotatable ring (13);
wherein the step of blocking signals output by the hall sensors (H7, H8, H9) when the electrical signal output by the hall sensors (H7, H8, H9) exceeding the set operation range is determined comprises the following step:
when the fourth operation voltage value does not fall within the fourth voltage operation reference line, determining the fourth operation voltage value exceeds the operation range and blocking the signals output by the hall sensors.

3. An electronic device , comprising a processor, an actuatable switch arranged with a magnet (20), and hall sensors (H7, H8, H9) arranged around the actuatable switch, wherein the processor stores an anti-interference program for the hall sensors (H7, H8, H9), the processor is configured to implement the anti-interference method for hall sensors (H7, H8, H9) according to any one of claims 1 to 2 when executing the anti-interference program for the hall sensors (H7, H8, H9).
